(19) Europäisches Patentamt
European Patent Office
Office européen des brevets

(11) **EP 4 517 358 A1**

(12) **EUROPEAN PATENT APPLICATION**

(43) Date of publication:
**05.03.2025 Bulletin 2025/10**

(21) Application number: **24197486.4**

(22) Date of filing: **30.08.2024**

(51) International Patent Classification (IPC):
***G01R 33/3815*** (2006.01)   ***G01R 33/3873*** (2006.01)

(52) Cooperative Patent Classification (CPC):
**G01R 33/3815; G01R 33/3873;** G01R 33/3802;
G01R 33/3875

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.09.2023 JP 2023143188**

(71) Applicants:
• **Japan Superconductor Technology Inc.
Kobe-shi, Hyogo 651-2271 (JP)**
• **RIKEN
Wako-shi, Saitama 351-0198 (JP)**

(72) Inventors:
• **HAMADA, Mamoru
Kobe-shi, 651-2271 (JP)**
• **KOMINATO, Kentaro
Kobe-shi, 651-2271 (JP)**
• **PIAO, Renzhong
Wato-shi, 351-0198 (JP)**
• **YAMAZAKI, Toshio
Wato-shi, 351-0198 (JP)**
• **YANAGISAWA, Yoshinori
Wato-shi, 351-0198 (JP)**

(74) Representative: **TBK
Bavariaring 4-6
80336 München (DE)**

(54) **SUPERCONDUCTING MAGNET DEVICE**

(57)    A superconducting magnet device includes a low temperature vessel disposed in a cylindrical shape around a central axis so as to surround a sample region including the central axis, the low temperature vessel internally having a low temperature region, a winding frame having a cylindrical shape centered on the central axis and disposed in the low temperature region, a superconducting coil including a superconducting wire wound around an outer periphery of the winding frame, the superconducting coil being excited to generate a magnetic field, a shim coil that is arranged in the sample region and generates a magnetic field by being excited, a sample region magnetic shim disposed in the sample region and cooperating with the shim coil to increase homogeneity of a magnetic field of the sample region, and a low temperature magnetic shim in the low temperature region and enhances homogeneity of a magnetic field.

FIG.1

EP 4 517 358 A1

## Description

Field of the Invention

The present invention relates to a superconducting magnet device, and an NMR device and an MRI device including the superconducting magnet device.

Background Art

Conventionally, nuclear magnetic resonance (NMR) devices capable of knowing a bonding state between molecules have been widely used in the fields of chemistry, medicine, agriculture, and industry. Since a strong magnetic field is desirable for such NMR measurement, the NMR device includes a superconducting magnet device. A superconducting coil formed by a superconducting material is used for the superconducting magnet device. For example, since transition of a metal-based superconductor to a superconducting state occurs in a cryogenic state, a superconducting coil using the metal-based superconductor is often continuously cooled by being immersed in cryogenic liquid helium stored in a vessel. In addition, a method of conductively cooling a superconducting coil using a cryogenic refrigerator without using liquid helium has also been put into practical use.

JP 63-272335 A discloses a technique in which a magnetic shim is attached to an inner wall of a wall on a measurement space side in a liquid helium vessel. With such a magnetic shim, the magnetic field formed in the measurement space by the superconducting coil can be further homogenized. In addition, it is possible to prevent the magnetic field homogeneity of the measurement space from being disturbed due to the influence of a temperature change in the room in which the device is installed, as compared with the case where the magnetic shim is mostly disposed in a measurement space at room temperature.

Summary of the Invention

In the technique described in JP 63-272335 A, although the magnetic shim is hardly affected by the temperature change because the magnetic shim is exposed to liquid helium, there is a problem that it is difficult to adjust the relative position between the magnetic shim and the superconducting coil at the time of manufacturing the device, and as a result, it is difficult to stably maintain magnetic field homogeneity in the measurement space.

The present invention has been made in view of the above problems, and an object thereof is to provide a superconducting magnet device that is less susceptible to a temperature change in a device installation environment and can stably maintain homogeneity of a generated magnetic field.

A superconducting magnet device according to one aspect of the present invention includes a low temperature vessel disposed in a cylindrical shape around a central axis so as to surround a sample region including the central axis, the low temperature vessel internally having a low temperature region, a winding frame having a cylindrical shape centered on the central axis and disposed in the low temperature region, a superconducting coil including a superconducting wire wound around an outer periphery of the winding frame, the superconducting coil being excited to generate a magnetic field, a shim coil that is arranged in the sample region and generates a magnetic field by being excited, a sample region magnetic shim disposed in the sample region and cooperating with the shim coil to increase homogeneity of a magnetic field of the sample region, and a low temperature magnetic shim that is held by the winding frame in the low temperature region and enhances homogeneity of a magnetic field of the sample region.

Brief Description of the Drawings

Fig. 1 is a schematic cross-sectional view of a superconducting magnet device according to an embodiment of the present invention;

Fig. 2 is a schematic cross-sectional view in which a part of the superconducting magnet device according to the embodiment of the present invention is enlarged, and is a cross-sectional view illustrating a shape of each magnetic field to be formed;

Fig. 3 is an enlarged cross-sectional view of a part of the superconducting magnet device according to the embodiment of the present invention;

Fig. 4 is an enlarged cross-sectional view of a part of a superconducting magnet device according to a modified embodiment of the present invention;

Fig. 5 is a graph illustrating transition of a Z1 component of a room temperature and a magnetic field after excitation of a superconducting magnet device in an example of the present invention;

Fig. 6 is a graph illustrating transition of a Z 1 component of a room temperature and a magnetic field after excitation of a superconducting magnet device in a comparative example compared with examples of the present invention; and Fig. 7 is a graph illustrating the magnitude of a heterogeneous component of each magnetic field component with respect to presence or absence of a magnetic shim of the superconducting magnet device according to the embodiment of the present invention.

Detailed Description

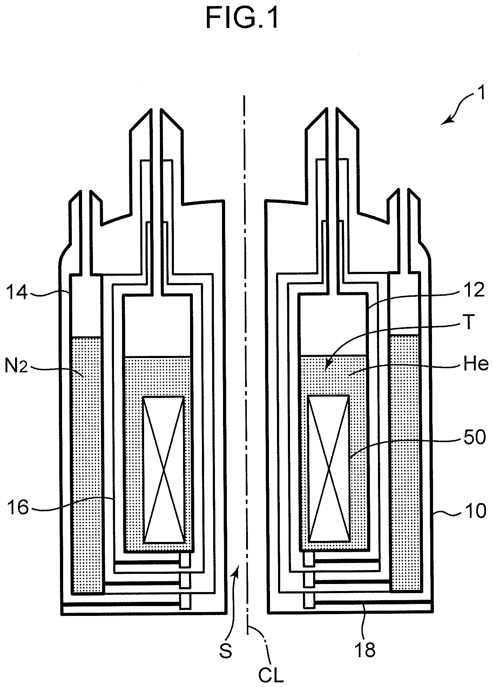

The present invention relates to a superconducting magnet device 1 that is a main component such as an NMR device (Nuclear Magnetic Resonance) and generates a static magnetic field to be applied to an object to be measured. The NMR device is used to measure a bonding state between molecules in the fields of chemistry, medicine, agriculture, and industry. Note that, as an example, in addition to the superconducting magnet device 1, the NMR device includes a sample holder (also referred to as a probe and including an NMR signal transmission reception antenna), an NMR signal transmitter/receiver, an NMR signal analyzer, an automatic sample exchange device with sample temperature adjustment, an automatic refrigerant supply device, and the like, which are not illustrated. The present invention relates to the superconducting magnet device 1 including a magnetic shim (magnetic piece, shim) for adjusting magnetic field homogeneity of a main magnetic field. Hereinafter, the superconducting magnet device 1 according to an embodiment of the present invention will be described with reference to the drawings. Fig. 1 is a schematic cross-sectional view of a superconducting magnet device 1.

The superconducting magnet device 1 includes a vacuum vessel 10, a helium tank 12 (low temperature vessel), a nitrogen tank 14, a radiation shield 16, a support structure 18, and a superconducting magnet 50. The inside of the vacuum vessel 10 is brought into a vacuum state by a vacuum pump, which is not illustrated, or the like. Specifically, after the inside of the vacuum vessel 10 is evacuated and cooled with the refrigerant, a predetermined vacuum valve is closed to seal off the vacuum, and the vacuum pump is disconnected and operated. As an example, the inner diameter of the vacuum vessel 10 based on a central axis CL is set to 54 mm, the outer diameter is set to 1000 mm, and the height of the vacuum vessel 10 is set to 1500 mm. The helium tank 12 is sealed so as to be able to store liquid helium He. The inside of the helium tank 12 corresponds to a low temperature region T in the present invention. That is, the helium tank 12 is arranged in a cylindrical shape around the central axis CL so as to surround a sample region S including the central axis CL, and has the low temperature region T therein.

The nitrogen tank 14 is sealed so as to be able to store liquid nitrogen $N_2$. Note that, in Fig. 1, a supply port for supplying each liquid or a gas release port through which each liquid is vaporized is simply illustrated in upper portions of the helium tank 12 and the nitrogen tank 14. Actually, various valves are provided in the supply port and the discharge port. Examples of the material of the vacuum vessel 10, the helium tank 12, and the nitrogen tank 14 include aluminum, stainless steel, and the like.

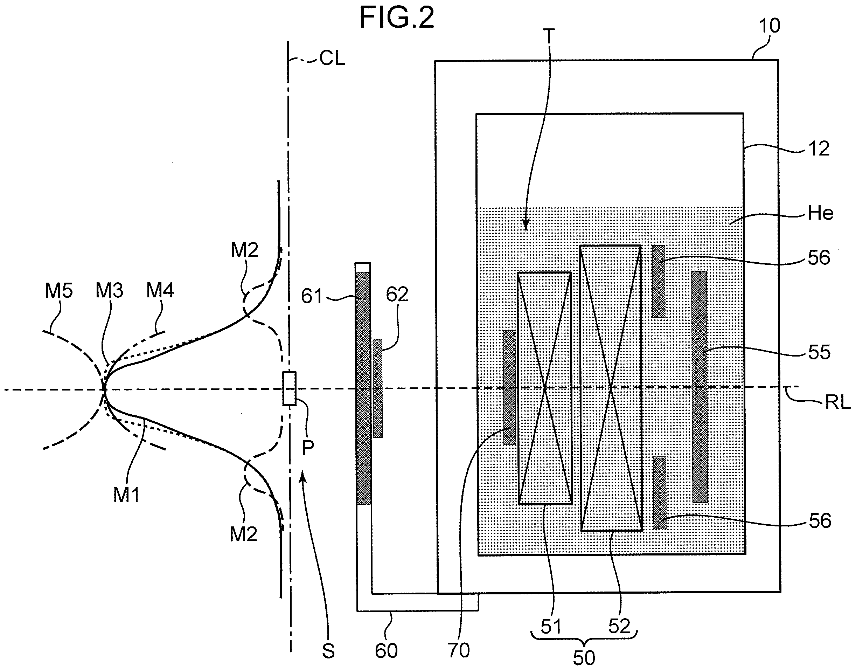

The helium tank 12, the nitrogen tank 14, and the vacuum vessel 10 have a three-dimensional annular shape with a multiple structure, and constitute a cryostat (cryogenic thermostatic device) that encloses and cools the superconducting magnet 50. In the present embodiment, these structures are disposed coaxially about the central axis CL of the superconducting magnet 50. The superconducting magnet 50 generates a magnetic field in which the direction of the magnetic field is parallel to the central axis CL. In the present embodiment, a sample P (object to be measured) (see Fig. 2) can be arranged inside the superconducting magnet 50, more specifically, in a sample region S (measurement space) at room temperature located inside the vacuum vessel 10 (near the central axis CL). Note that the sample region S is not limited to the normal temperature. For example, a temperature-variable sample holder may be inserted into the sample region S in the superconducting magnet to lower or increase the temperature of the sample region S.

The radiation shield 16 is a shield vessel that is cooled by the cold of the helium gas so as not to further release the cold. In addition, the radiation shield 16 may be forcibly cooled by a refrigerator not illustrated. Examples of the material of the radiation shield 16 include aluminum, copper, and the like.

The superconducting magnet 50 generates a strong magnetic field for measurement in the superconducting magnet device 1. For this reason, the superconducting magnet 50 is cooled to a cryogenic temperature state and is maintained in a superconducting state. The superconducting magnet 50 is accommodated in the helium tank 12 so as to be immersed in liquid helium in the helium tank 12. The helium tank 12 containing the superconducting magnet 50 in this manner is housed in the vacuum vessel 10 and vacuum-insulated. As a result, evaporation of liquid helium having a boiling point of 4.2 K at atmospheric pressure is suppressed.

In the superconducting magnet device 1 used for an NMR device or the like, it is required that the magnetic field homogeneity in the measurement space is extremely high, that is, the magnetic flux density is uniform and has no gradient, and the spatial change in the magnetic flux density is extremely small. Accordingly, in order to achieve such high homogenization of a magnetic field, a coil shape, current density, and the like of the superconducting magnet that generates the main magnetic field are devised at the design stage. However, there is a case where desired magnetic field homogeneity cannot be obtained due to a case where manufacturing accuracy as designed cannot be obtained, or an influence of a ferromagnetic material that causes disturbance such as a reinforcing bar in a reinforced concrete building existing in a device installation place, for example. For this reason, conventionally, a superconducting magnet device includes a magnetic shim for magnetic field correction for correcting heterogeneity of a main magnetic field by a superconducting magnet and obtaining high magnetic field homogeneity.

The inventors of the present invention first disposed the magnetic shim on the inner wall of the helium tank 12, disposed a superconducting magnet in the helium tank 12, filled liquefied helium in the helium tank 12, and earnestly evaluated the magnetic field homogeneity, and as a result, the present inventors have found the problem that it is difficult to reproduce the relative position between the magnetic shim and the superconducting magnet as intended, and there is a limit in correcting the magnetic field of the superconducting magnet by the magnetic shim located outside the magnetic shim.

In order to solve the above problem, a structure of the superconducting magnet device 1 according to the present invention conceived based on a new idea will be described in more detail. Fig. 2 is a schematic cross-sectional view in which a part of the superconducting magnet device 1 according to the present embodiment is enlarged, and is a cross-sectional view illustrating the shape of each magnetic field to be formed. Note that the actual device has a shape in which the structure on the right side of the central axis CL in Fig. 2 is rotated once around the central axis CL.

<Structure of superconducting magnet device>

In the superconducting magnet device 1, a coil using an oxide superconductor and a coil using a low temperature superconductor (a main coil and a correction coil) are concentrically installed, and a desired magnetic field is generated in the sample region S as a whole. At this time, since the magnetic field received by the wire becomes higher toward the center of the coil (closer to the central axis), it is necessary to use a material capable of maintaining a current density corresponding to the magnetic field. For example, an oxide superconductor is used at the highest magnetic field, $Nb_3Sn$ is used at the second highest magnetic field, and NbTi is used at the weakest magnetic field. As an example, an oxide superconductor is used under a magnetic field condition of 18 T or more, NbsSn is used under a magnetic field condition of 9 T or more, and NbTi is used under a magnetic field condition of 9 T or less. In general, since the cost of the superconductor decreases in the order of these three, it is desirable to use NbTi having a low unit price at a place where the magnetic field is weak. Of course, an oxide superconductor may be used under any magnetic field condition. Note that the oxide superconductor can have a high current density, and thus has an advantage that the overall size of the magnet is reduced. While there is a case where a current having the same value flows through each of the coils, there is a case where a current having a different value flows through each of the coils.

The superconducting magnet device 1 will be described in more detail with reference to Fig. 2. The superconducting magnet 50 described above includes an oxide superconducting coil 51 (superconducting coil) and a metal-based superconducting coil 52. Further, the superconducting magnet device 1 further includes a metal-based superconducting shim coil 55, a pair of upper and lower metal-based compensation coils 56, a support 60, a room temperature shim coil 61, a room temperature iron shim 62 (sample region magnetic shim), and a low temperature iron shim 70 (low temperature magnetic shim).

The oxide superconducting coil 51 has a cylindrical shape centered on the central axis CL. The oxide superconducting coil 51 is configured by winding a superconducting wire formed by an oxide superconductor around a predetermined winding frame. In order for the oxide superconducting coil 51 to function as a high temperature superconducting coil, $Bi_2Sr_2CaCu_2Ox$ (Bi-2212) or $Bi_2Sr_2Ca_2Cu_3Oy$ (Bi-2223), which is a known bismuth-based oxide, or REBCO ($REBa_2Cu_3Oy$, RE is rare earth elements) can be used as the oxide superconductor. When a predetermined drive current flows through the oxide superconducting coil 51 and is excited, the oxide superconducting coil 51 generates a magnetic field in the sample region S. Note that the detailed structure of the oxide superconducting coil 51 will be further described later together with the low temperature iron shim 70.

The metal-based superconducting coil 52 is disposed so as to surround the oxide superconducting coil 51, and has a cylindrical shape centered on the central axis CL. The metal-based superconducting coil 52 is configured by winding a metal-based superconducting wire around a predetermined winding frame. In order for the metal-based superconducting coil 52 to function as a low temperature superconducting coil, niobium tin ($Nb_3Sn$) or niobium titanium (NbTi) can be used as the metal for the conducting wire. Similarly to the oxide superconducting coil 51, the metal-based superconducting coil 52 is also excited to generate a magnetic field in the sample region S. Note that, instead of the metal-based superconducting coil 52, a superconducting coil similar to the oxide superconducting coil 51 may be disposed at the position of the metal-based superconducting coil 52.

The metal-based superconducting shim coil 55 is disposed so as to surround the metal-based superconducting coil 52 from radially outside, and has a cylindrical shape centered on the central axis CL. The metal-based superconducting shim coil 55 has a thin layer shape compared to the metal-based superconducting coil 52, and is configured by winding a metal-based superconducting wire around a predetermined winding frame as a low temperature superconducting coil. Similarly to the oxide superconducting coil 51, the metal-based superconducting shim coil 55 is also excited to generate a magnetic field in the sample region S. As an example, the inner diameter of the metal-based superconducting shim coil 55 based on the central axis CL is set to 600 mm.

Note that there are two types of shim coils. Specifically, there are a coil that is wound like a main coil to adjust an axial component (axial shim coil) and a coil that is wound in a rectangular shape in advance in a planar manner and is fixed by attaching the coil in a saddle shape after winding the axial shim (radial shim coil).

The pair of upper and lower metal-based compensation coils 56 is disposed between the metal-based superconducting coil 52 and the metal-based superconducting shim coil 55 in the radial direction. The metal-based compensation coils 56 each have a cylindrical shape centered on the central axis CL, and are disposed to face an upper end portion and a lower end portion of the metal-based superconducting coil 52, respectively. Each of the metal-based compensation coils 56 is also configured by winding a metal-based superconducting wire, for example, NbTi, around a predetermined winding frame, and generates a magnetic field in the sample region S by being excited (low temperature superconducting coil) similarly to the oxide superconducting coil 51. Note that, although a pair of upper and lower metal-based compensation coils 56 is illustrated in Fig. 2, two pairs of metal-based compensation coils 56 may be provided, or a configuration may be employed in which one obtained by further adding one coil to the pair of metal-based compensation coils 56, for example, one obtained by reducing the size of the main coil is placed at the center in the axial direction.

The support 60 is disposed in the sample region S. The support 60 includes a cylindrical portion centered on the central axis CL and a disk portion connected to a lower end portion of the cylindrical portion. An outer peripheral portion of the disk portion is fixed to a bottom surface of the vacuum vessel 10.

The room temperature shim coil 61 (shim coil) is a cylindrical coil provided on the support 60 so as to be arranged in the sample region S. The room temperature shim coil 61 is also configured by winding a metal-based superconducting wire, for example, copper, around a predetermined winding frame, and generates a magnetic field in the sample region S by being excited similarly to the oxide superconducting coil 51. As an example, in the present embodiment, the room temperature shim coil 61 is constituted by a copper coil. Further, the inner diameter of the room temperature shim coil 61 based on the central axis CL is set to 44 mm. Note that the name "room temperature" of the room temperature shim coil 61 in the present embodiment is used as an example for description, and does not limit the present invention. The same applies to names of other members hereinafter.

The room temperature iron shim 62 is fixed to the support 60 so as to be disposed on the outer peripheral side of the room temperature shim coil 61. Note that the room temperature iron shim 62 may be attached to another winding frame (pipe) in addition to being fixed to the support 60. The room temperature iron shim 62 is constituted by electromagnetic soft iron, but may be constituted by pure iron. In another embodiment, the room temperature iron shim 62 may be constituted by a metal containing a ferromagnetic material such as nickel or cobalt other than iron as a main component. Note that no current flows through the room temperature iron shim 62. In addition, the room temperature iron shim 62 has a function of correcting (adjusting) a magnetic field formed in the sample region S as a magnetic body, and enhances homogeneity of the magnetic field of the sample region S in cooperation with the room temperature shim coil 61. Note that, although one room temperature iron shim 62 is illustrated in Fig. 2, actually, a plurality of room temperature iron shims 62 is arranged around the room temperature shim coil 61 according to the shape of the magnetic field. In particular, the room temperature iron shim 62 has a function of correcting a low-order radial component of the magnetic field formed in the sample region S as described later. Note that the main function of the room temperature iron shim 62 is to correct the lower-order radial component, but the axial component or the higher-order radial component may be corrected.

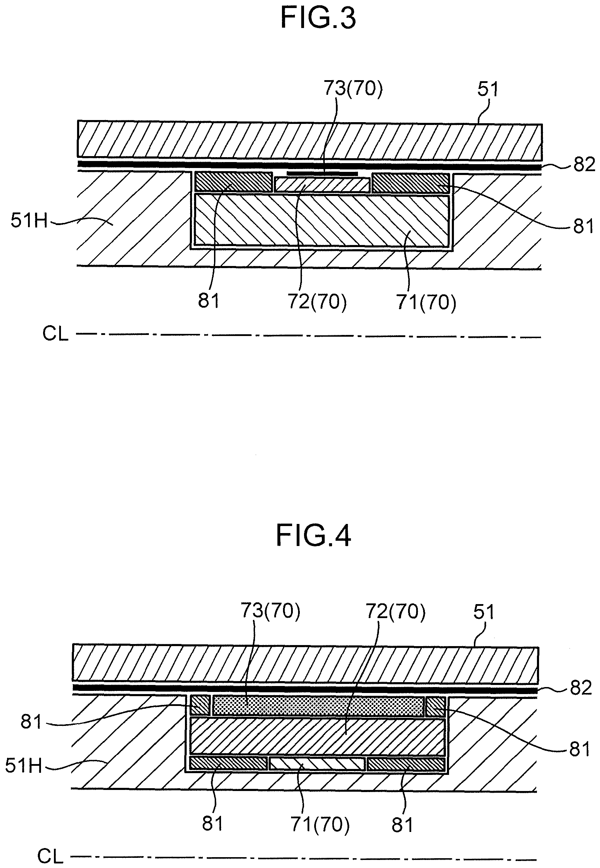

The low temperature iron shim 70 is arranged in a low temperature region T formed by liquid helium. In particular, in the present embodiment, the low temperature iron shim 70 is held by a winding frame 51H (Fig. 3) of the oxide superconducting coil 51. The low temperature iron shim 70 is constituted by electromagnetic soft iron similarly to the room temperature iron shim 62, but may be a magnetic shim constituted by other materials. As described later, the low temperature iron shim 70 has a function of particularly correcting a Z2 component of the magnetic field formed in the sample region S.

Note that, as illustrated in Fig. 2, the superconducting magnet 50 (the oxide superconducting coil 51 and the metal-based superconducting coil 52), the metal-based superconducting shim coil 55, the metal-based compensation coil 56, the room temperature shim coil 61, and the low temperature iron shim 70 are arranged vertically symmetrically (substantially symmetrically) with respect to a horizontal reference line RL passing through a portion of the sample region S where the sample P is arranged. Note that these members are not limited to those arranged symmetrically. For example, when another current path is arranged above the coil, and the influence of the magnetic field due to the arrangement is large, the arrangement of the correction coil may be made asymmetric to correct the magnetic field component created by the current path.

<Magnetic field of superconducting magnet device>

As described above, in the superconducting magnet device 1, it is required that the magnetic field homogeneity of the sample region S serving as the measurement space is extremely high, that is, the magnetic flux density is uniform and has no gradient, and the spatial change in the magnetic flux density is extremely small. The present inventor has newly found that the magnetic field in the superconducting magnet device 1 illustrated in Fig. 2 is homogenized as follows. Note that a graph illustrated by each M in Fig. 2 schematically illustrates the magnitude and distribution of the magnetic field formed on the central axis CL.

A first magnetic field M1 is formed on the central axis CL by the superconducting magnet 50 provided in the low temperature region T. Although the first magnetic field M1 is arranged substantially symmetrically in the vertical direction with respect to the reference line RL, a flat region is hardly formed at the top thereof. Thus, by disposing the pair of upper and lower metal-based compensation coils 56 outside the superconducting magnet 50 in the low temperature region T, a pair of second magnetic fields M2 is formed on the central axis CL. When the magnetic field of the pair of second magnetic fields M2 acts on the first magnetic field M1, a third magnetic field M3 in which the top of the first magnetic field M1 is flattened is expected to be formed.

However, since a shielding current is generated in the oxide superconducting coil 51 constituted by an oxide superconductor, a fourth magnetic field M4 as a shielding magnetic field is formed. In this case, the effect of the pair of second magnetic fields M2 is weakened, and it becomes difficult to form a flat magnetic field like the third magnetic field M3. Accordingly, in the present embodiment, by disposing the low temperature iron shim 70 inside the oxide superconducting coil 51, the fifth magnetic field M5 that cancels the fourth magnetic field M4 is formed, and the homogeneous third magnetic field M3 can be formed.

In particular, in the present embodiment, the low temperature iron shim 70 can greatly improve the homogeneity of the magnetic field in the direction parallel to the central axis CL. Furthermore, the position of the room temperature iron shim 62 arranged around the room temperature shim coil 61 is set so as to enhance the homogeneity of the magnetic field in the circumferential direction when viewed in the cross section orthogonal to the central axis CL. That is, by arranging the plurality of room temperature iron shims 62 around the room temperature shim coil 61, a magnetic field distribution in a cross section orthogonal to the central axis CL can be brought close to a perfect circle.

Next, functions of the low temperature iron shim 70 and the room temperature shim coil 61 will be further described using a known function expansion formula of a magnetic field. When the coordinate system in the sample region S is represented by r, $\theta$, and $\varphi$, the function expansion of the magnetic field can be expressed by the following Equation 1. Note that r represents a distance from the center, and $\theta$ and $\varphi$ represent directions from the origin by angles.
[Formula 1]

$$B_z(r, \theta, \phi) = \sum_{n=0}^{n=\infty} \sum_{m=0}^{m=n} (n+m+1)\, r^n\, P_n{}^m(\cos\theta) \left[ A_{n+1}{}^m \cos m\phi + B_{n+1}{}^m \sin m\phi \right]$$

$$\cdots \text{(Equation 1)}$$

Equation 1 can be rewritten as Equation 2 below.
[Formula 2]

$$B_z = \sum_{n=0}^{n=\infty} \sum_{m=0}^{m=n} r^n P_n{}^m(\cos\theta) \left[ A'_{n+1}{}^m \cos m\phi + B'_{n+1}{}^m \sin m\phi \right]$$

$$\cdots \text{(Equation 2)}$$

Furthermore, the lower-order term of Equation 2 can be expressed as the following Equation 3. Note that, in the following Equation 3 and subsequent equations, terms having higher orders are omitted.
[Formula 3]

$$B_z(r, \theta, \phi) = A'_1{}^0 + A'_1{}^0 r\cos\theta - A'_2{}^1 r\sin\theta \cos\phi - B'_2{}^1 r\sin\theta \sin\phi + (1/2)A'_3{}^0 r^2(3\cos^2\theta - 1)$$
$$- 3A'_3{}^1 r^2\sin\theta \cos\theta \cos\phi - 3B'_3{}^1 r^2\sin\theta \cos\theta \sin\phi + 3A'_3{}^2 r^2\sin^2\theta \cos 2\phi$$
$$+ 3B'_3{}^2 r^2\sin^2\theta \sin 2\phi + \ldots$$
$$\cdots \text{(Equation 3)}$$

When Equation 3 is rewritten to a coordinate system of X, Y, and Z, Equation 4 can be expressed as follows.
[Formula 4]

$$B_z(x,y,z) = A'^0_1 + A'^0_1 z - A'^1_2 x - B'^1_2 y + A'^0_3(z^2 - (1/2)(x^2+y^2)) - 3A'^1_3 zx - 3B'^1_3 zy + 3A'^2_3(x^2-y^2) + 3B'^2_3(2xy) + \ldots$$

$$\cdots \text{ (Equation 4)}$$

When Equation 4 is rewritten into a symbolic form, Equation 5 can be expressed as follows.
[Formula 5]

$$B_z(x,y,z) = A''^0_1 + A''^0_1 z - A''^1_2 x - B''^1_2 y + A''^0_3 z^2 - A''^1_3 zx - B''^1_3 zy + A''^2_3 c^2 + B''^2_3 s^2 + \ldots$$

$$\cdots \text{ (Equation 5)}$$

Note that the terms on the right side of Equation 5 are referred to as a constant term, a Z1 term, an X term, a Y term, a Z2 term, a ZX term, a ZY term, a C2 term, and an S2 term from the left side. In Equation 4, the fifth term on the right side corresponds to the axial component, and the X term, the Y term, the ZX term, the ZY term, the C2 term, and the S2 term of Equation 5 correspond to the radial component. Note that the radial component can be said to be a term including not only Z but also an element in Equation 5. Here, there is a feature that how much the axial component is generated is easily predicted in advance by calculation. On the other hand, the radial component is relatively difficult to predict in advance by calculation, and its influence is difficult to understand unless the superconducting magnet device 1 is manufactured, immersed in the helium tank 12, and the magnetic field is actually measured. Based on the characteristics of the axial component and the radial component, the present inventors have conceived of enhancing magnetic field homogeneity by using the above-described room temperature iron shim 62 and low temperature iron shim 70.

That is, since the low temperature iron shim 70 is disposed in the low temperature region T, even if the room temperature of the sample region S changes, the relative position with respect to the oxide superconducting coil 51 does not change, so that the magnetic field component is stabilized. However, in order to adjust the degree of influence of the low temperature iron shim 70, it is necessary to disassemble the superconducting magnet device 1, and thus it is difficult to perform adjustment after manufacturing.

On the other hand, the room temperature iron shim 62 can correct the magnetic field by appropriately disposing the room temperature iron shim 62 on the support 60 even after manufacturing the superconducting magnet device 1 with respect to a generated magnetic field heterogeneous component, and the magnetic field homogeneity can be further improved by repeating trial and error. However, there is a possibility that the relative position between the room temperature iron shim 62 and the oxide superconducting coil 51 is shifted due to a temperature change in the sample region S. This shift in the relative position is caused by a difference in expansion and contraction particularly in the Z direction (axial direction of the central axis CL) between the room temperature iron shim 62 and the low temperature iron shim 70 due to a difference in temperature change between the sample region S and the low temperature region T. As described above, when the relative positional relationship between the room temperature iron shim 62 and the oxide superconducting coil 51 is shifted, there is a problem that a magnetic field component (particularly, Z1 component and Z2 component) is affected and time is likely to fluctuate. This problem can be solved by the low temperature iron shim 70 as previously described.

From the above, the present inventors have found that it is preferable to correct the large axial component contained in the magnetic field formed in the sample region S with the low temperature iron shim 70 and correct the radial component with the room temperature iron shim 62.

In other words, in the superconducting magnet device 1 illustrated in Fig. 2, a Z1 component that is difficult to predict in advance can be corrected by the metal-based superconducting shim coil 55. Then, the low temperature iron shim 70 corrects most (80% or more) of the Z2 heterogeneous component that can be predicted by calculation. Furthermore, the residual Z2 heterogeneous component can be completely corrected by the room temperature shim coil 61. In addition, a part (particularly lower order terms such as X, Y, ZX, and ZY) of a radial heterogeneous component that is difficult to predict in advance is corrected by the room temperature iron shim 62 disposed on the outer peripheral surface of the room temperature shim coil 61. Then, the residual radial heterogeneous component is completely corrected by the room temperature shim.

With the above configuration, the superconducting magnet device 1 is hardly affected by the temperature change in the installation environment of the superconducting magnet device 1, and the homogeneity of the generated magnetic field can be stably maintained. Note that, as described above, in the present embodiment, the large axial component is corrected by the low temperature iron shim 70, but the low temperature iron shim 70 may include a radial component correction function. In this case, in terms of configuration, it is assumed that the correction amount can be calculated in advance or an approximate value is to be corrected.

<Structure of oxide superconducting coil>

Fig. 3 is an enlarged cross-sectional view of the superconducting magnet 50 (a part of the superconducting magnet device 1) according to the present embodiment. Note that, in Fig. 3, the axial size of the central axis CL is reduced as compared with Fig. 2. The superconducting magnet device 1 has a winding frame 51H for supporting the oxide superconducting coil 51. The winding frame 51H has a cylindrical shape centered on the central axis CL, and is constituted by stainless steel as a non-magnetic material, for example. The winding frame 51H is disposed in the low temperature region T.

As described above, the oxide superconducting coil 51 is constituted by a superconducting wire wound around the outer periphery of the winding frame 51H, and generates a magnetic field by being excited. As illustrated in Fig. 3, the outer peripheral portion of the winding frame 51H is provided with a recess (engagement portion) formed by partially reducing the outer diameter thereof and capable of accommodating the low temperature iron shim 70. The low temperature iron shim 70 (low temperature magnetic shim) is held by the winding frame 51H in the low temperature region T by being disposed in the recess. That is, the recess has a function of engaging with at least a part of the low temperature iron shim 70. As a result, the low temperature iron shim 70 is held by the winding frame 51H so as to be sandwiched between the winding frame 51H and the oxide superconducting coil 51 (superconducting wire).

The low temperature iron shim 70 includes a first shim 71, a second shim 72, and a third shim 73. Each of these shims is constituted by an iron foil material. The first shim 71 is wound around the winding frame 51H so as to be fitted in a recess formed in the winding frame 51H. Further, the second shim 72 is wound around an outer peripheral surface of the first shim 71, and the third shim 73 is wound around an outer peripheral surface of the second shim 72. Further, as will be described in detail in Examples described later, the first shim 71, the second shim 72, and the third shim 73 are sequentially set to have a smaller width and a smaller thickness in the axial direction. Note that the center positions of the three shims are aligned so as to coincide with each other. Further, an axial width of the first shim 71 is set to correspond to the width of the recess formed in the winding frame 51H.

In addition, since the second shim 72 and the third shim 73 are smaller in size in the axial direction than the first shim 71, spaces are formed on both sides of the second shim 72 and the third shim 73. Thus, in the present embodiment, a pair of spacers 81 is disposed so as to fill the space. Note that, in Fig. 3, the thickness of each shim is set so that the surface of the third shim 73 is flush with the surface of the winding frame 51H. Furthermore, an insulating sheet 82 is wound so as to cover the low temperature iron shim 70 from the outside, and a superconducting wire material is wound on the outside thereof to form the oxide superconducting coil 51.

On the other hand, Fig. 4 is an enlarged cross-sectional view of a superconducting magnet 50 according to a modified embodiment of the present invention. In this example, the thickness relationship among the first shim 71, the second shim 72, and the third shim 73 is set to be different from that in the example of Fig. 3. Further, an axial width of the second shim 72 is set to correspond to the width of the recess formed in the winding frame 51H. The axial width of the first shim 71 is set to be smaller than the width of the second shim 72, and the axial width of the third shim 73 is set to be smaller than the width of the second shim 72 and larger than the width of the first shim 71.

In the present modified embodiment, the spacers 81 are disposed in spaces formed on both sides of the first shim 71 and on both sides of the third shim 73. Other structures are similar to those in Fig. 3.

As described above, in each embodiment of the present invention, the superconducting magnet device 1 includes at least the helium tank 12, the winding frame 51H, the oxide superconducting coil 51, the room temperature iron shim 62, and the low temperature iron shim 70. With such a configuration, the magnetic field of the portion of the sample region S where the sample P is disposed can be stabilized and homogenized. In addition to the function of winding the superconducting wire, which is an original function of the winding frame 51H, the winding frame 51H can have a function of holding the low temperature iron shim 70. Thus, the low temperature iron shim 70 stable against temperature change and electromagnetic force can be held in the low temperature region T by the winding frame 51H which is a structural basic portion of the superconducting magnet device 1. As a result, a dedicated holding member for holding the low temperature iron shim 70 becomes unnecessary, and the superconducting magnet device 1 can be configured with a simple structure and the space of the superconducting magnet device 1 can be saved.

Further, by using such a superconducting magnet device 1 in an NMR device, a measurement function of the NMR device can be stably implemented.

Furthermore, in the above embodiment, the low temperature iron shim 70 is held by the winding frame 51H so as to be sandwiched between the winding frame 51H and the oxide superconducting coil 51.

With such a configuration, the low temperature iron shim 70 is firmly sandwiched between the winding frame 51H and the superconducting wire of the oxide superconducting coil 51. Therefore, even during cooling or coil excitation, the position of the low temperature iron shim 70 is stably maintained in both the radial direction and the axial direction of the winding frame 51H. In addition, since the low temperature iron shim 70 is held by the winding frame 51H having high rigidity, vibration-proof performance against vibration transmission from the outside is high, and sufficient seismic resistance against an earthquake is expected.

In the achievement of the magnetic field homogeneity as described above, when the contribution ratio of the low temperature iron shim 70 is larger than the contribution ratio of the metal-based superconducting shim coil 55, the room temperature shim coil 61, or the room temperature iron shim 62, it is beneficial to stably maintain the position of the low temperature iron shim 70 in utilizing the magnetic field as described above. In addition, since a jig for fixing the low temperature iron shim 70 is not individually manufactured and the low temperature iron shim 70 is integrated with the winding frame 51H of the oxide superconducting coil 51, the temperature distribution of the low temperature iron shim 70 hardly occurs, and the magnetic field correction can be accurately performed.

Note that, if the low temperature iron shim 70 is fixed to another fragile winding frame, vibration from the outside may propagate to induce natural vibration. In this case, a side band may be generated in the NMR signal in the NMR device. Furthermore, at the time of an earthquake, the NMR device may be broken due to the natural vibration. In the NMR device including the superconducting magnet device 1 according to the present embodiment, the occurrence of such a problem can also be reduced.

Further, in the above embodiment, the winding frame 51H has an engagement portion that engages with at least a part of the low temperature iron shim 70. The engagement portion is appropriately set at a place where the low temperature iron shim 70 can efficiently correct a magnetic field error. With such a configuration, when the low temperature iron shim 70 is held by the winding frame 51H, the engagement portion can have a function of positioning the low temperature iron shim 70 and the winding frame 51H. In particular, since the centers of the oxide superconducting coil 51 and the low temperature iron shim 70 can be accurately matched, the low temperature iron shim 70 is less likely to generate a magnetic error.

Furthermore, in the above embodiment, the engagement portion is a recess formed in the outer peripheral portion of the winding frame 51H and capable of accommodating at least a part of the low temperature iron shim 70. A part or the whole of the low temperature iron shim 70 is accommodated in such a groove-shaped recess, whereby the position of the low temperature iron shim 70 with respect to the oxide superconducting coil 51 can be stably maintained. In addition, since the low temperature iron shim 70 is fitted into the recess, it is possible to suppress movement of the low temperature iron shim 70 due to the electromagnetic force between the low temperature iron shim 70 and the oxide superconducting coil 51.

Further, in the above configuration, since at least a part of the superconducting wire of the oxide superconducting coil 51 is constituted by an oxide superconductor, a stable magnetic field can be generated and maintained even when the temperature of the sample region S changes.

Note that the low temperature iron shim 70 may have a first low temperature magnetic shim and a second low temperature magnetic shim. In the former, at least a magnetic field component parallel to the central axis CL in the coil magnetic field formed in the sample region S by the oxide superconducting coil 51 is homogenized. On the other hand, the latter homogenizes the magnetic field component along the circumferential direction in the cross section orthogonal to the central axis CL in the coil magnetic field. In other words, the first low temperature magnetic shim is an axial iron shim that corrects the axial component, and the second low temperature magnetic shim corresponds to a radial iron shim that corrects the radial component.

With such a configuration, since a stable and homogeneous magnetic field can be formed in both the axial direction and the radial direction in the sample region S, the measurement function of the NMR device can be stably and accurately expressed.

Examples

Next, a superconducting magnet device 1 according to the present invention will be further described based on Examples. Note that the present invention is not limited to the following Examples.

<Evaluation of low temperature magnetic shim>

The low temperature iron shim 70 illustrated in Figs. 3 and 4 was produced experimentally, and the superconducting magnet device 1 was excited to evaluate each component of the magnetic field formed on the central axis CL of the sample region S. Table 1 shows parameters of the low temperature iron shim 70 produced experimentally.

[Table 1]

|  | EXAMPLE 1 | EXAMPLE 2 | EXAMPLE 3 |
|---|---|---|---|
| No.1 INNER DIAMETER(mm) | 78.00 | 78.00 | 78.00 |

(continued)

|  | EXAMPLE 1 | EXAMPLE 2 | EXAMPLE 3 |
|---|---|---|---|
| No.1 OUTER DIAMETER(mm) | 78.58 | 78.12 | 78.10 |
| No.1 WIDTH(mm) | 67.50 | 25.59 | 23.03 |
| No.1 THICKNESS(mm) | 0.29 | 0.06 | 0.05 |
| No.2 INNER DIAMETER(mm) | 78.58 | 78.12 | 78.10 |
| No.2 OUTER DIAMETER(mm) | 78.68 | 78.45 | 78.42 |
| No.2 WIDTH(mm) | 25.50 | 73.36 | 68.70 |
| No.2 THICKNESS(mm) | 0.05 | 0.17 | 0.16 |
| No.3 INNER DIAMETER(mm) | 78.68 | 78.45 | 78.42 |
| No.3 OUTER DIAMETER(mm) | 78.70 | 78.72 | 78.66 |
| No.3 WIDTH(mm) | 18.60 | 62.55 | 60.88 |
| No.3 THICKNESS(mm) | 0.01 | 0.13 | 0.12 |
| TOTAL THICKNESS(mm) | 0.35 | 0.36 | 0.33 |

Example 1 corresponds to an aspect of Fig. 3, and Examples 2 and 3 correspond to an aspect of Fig. 4. In Table 1, No. 1 corresponds to the first shim 71, No. 2 corresponds to the second shim 72, and No. 3 corresponds to the third shim 73. The inner diameter and the outer diameter are an inner diameter and an outer diameter of each shim having a cylindrical shape centered on the central axis CL, the width is a width in a direction parallel to the central axis CL, and the thickness corresponds to half of a difference between the inner diameter and the outer diameter. Note that, in each example, a recess is formed in the winding frame 51H at a depth corresponding to the total thickness of the shim.

Table 2 shows the magnitudes of the magnetic field components of Z4, Z6, Z8, and Z10 and the sum of their absolute values in each of Examples 1, 2, and 3. Note that the numbers Z4 to Z10 correspond to the order of Z in Equation 4.

[Table 2]

|  | EXAMPLE 1 | EXAMPLE 2 | EXAMPLE 3 |
|---|---|---|---|
| Z2(ppm/cm$^2$) | 27.93 | 27.94 | 27.94 |
| Z4(Hz/cm$^4$) | -1.480 | -2.000 | -0.040 |
| Z6(Hz/cm$^6$) | 3.728 | -0.962 | -4.314 |
| Z8(Hz/cm$^8$) | -2.419 | -1.500 | -2.318 |
| Z10(Hz/cm$^{10}$) | 0.019 | -0.048 | 0.067 |
| SUM OF ABSOLUTE VALUES OF Z4 TO Z10 | 8.40 | 4.51 | 6.74 |

As illustrated in Table 2, in any of the examples, it was confirmed that design calculation can be performed so that the Z2 component is generated in an amount of about 27.9 ppm (= 25.1 KHz/cm$^2$) while the sum of the absolute values of the Z4 to Z10 magnetic field components is less than 10.

<Time stability of magnetic field component>

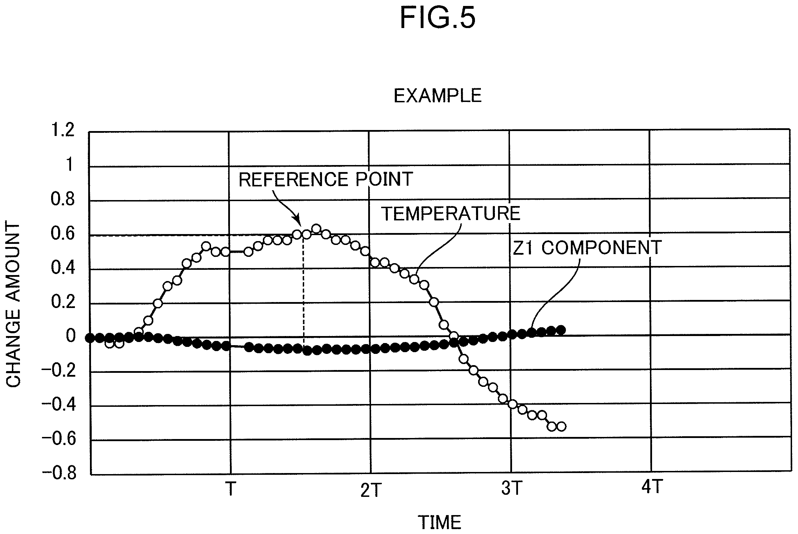

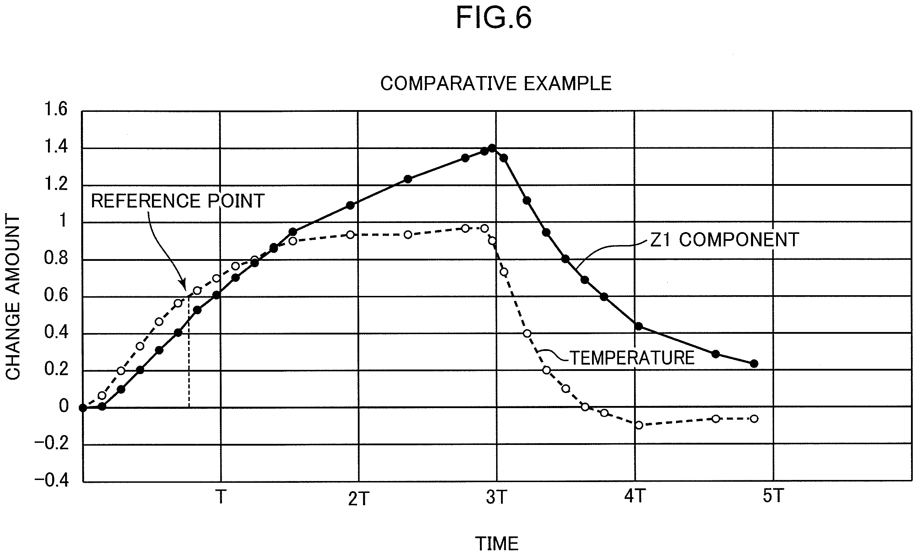

Fig. 5 is a graph illustrating transition of the Z1 component of a room temperature and a magnetic field after excitation of the superconducting magnet device 1 in the example of the present invention. Fig. 6 is a graph illustrating transition of the Z1 component of a room temperature and a magnetic field after excitation of a superconducting magnet device in a comparative example compared with the example of the present invention.

In this experiment, with respect to the presence or absence of the low temperature iron shim 70 (the low temperature magnetic shim) in Fig. 2, the relationship between the temperature and the Z1 component was evaluated by changing the room temperature of the environment in which the NMR device was installed. Note that, in Figs. 5 and 6, the graph of the temperature represents the surface temperature of the vacuum vessel 10 (cryostat), and the change amount 1 on the vertical axis corresponds to a temperature change of 3 degrees. Further, in the graph of the Z1 component, the change amount 1 on the vertical axis corresponds to a change of the magnetic field component -500 Hz/cm.

At the reference point of the comparative example of Fig. 6, a change in the Z1 component of -225 Hz/cm occurs when the temperature changes by +1.8 degrees (0.6 × 3 degrees). On the other hand, at the reference point of the example of Fig. 5, when the temperature changes by +1.8 degrees (0.6 × 3 degrees), the change is only in the Z1 component of +38 Hz/cm. As described above, the change of the Z1 component could be suppressed to about 1/6 by the low temperature iron shim 70. As a result, the magnetic field component was stabilized, and NMR measurement for a long time became possible.

<Correction by low temperature magnetic shim and room temperature magnetic shim>

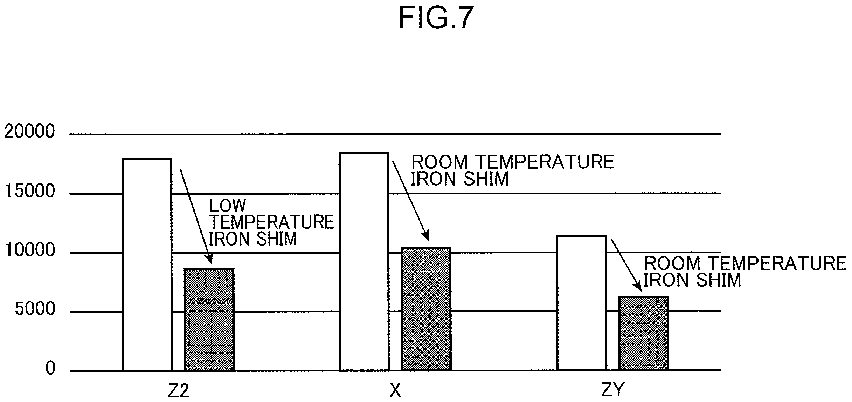

Fig. 7 is a graph illustrating the magnitude (absolute value) of a heterogeneous component (variation amount) of each magnetic field component with respect to the presence or absence of the magnetic shim (the room temperature iron shim 62 and the low temperature iron shim 70) of the superconducting magnet device 1 according to the embodiment of the present invention. In this experiment, the influence of the magnetic shim on the Z2 component, the X component, and the ZY component of the magnetic field was evaluated. The graph on the left side of each magnetic field component in Fig. 7 corresponds to a case where no magnetic shim is disposed. On the other hand, the graph on the right side of each magnetic field component corresponds to a case where the room temperature iron shim 62 and the low temperature iron shim 70 are provided. It was confirmed that the Z2 component can greatly reduce the heterogeneous component by the effect of the low temperature iron shim 70, and the X component and the ZY component can greatly reduce the heterogeneous component by the effect of the room temperature iron shim 62. Note that the heterogeneity of each magnetic field component remaining after the reduction can be sufficiently corrected by the room temperature shim coil 61.

Although the superconducting magnet device 1 according to the present invention has been described above, the present invention is not limited to these forms, and the following modified embodiments are possible.

(1) The above embodiment has been described in an aspect in which the superconducting magnet device 1 is applied to an NMR device, but the present invention is not limited thereto. The superconducting magnet device 1 may be applied to a magnetic resonance imaging (MRI) device.

(2) Further, the above embodiment has been described in an aspect in which the low temperature iron shim 70 is held by the winding frame 51H on the outer peripheral side of the winding frame 51H, but the low temperature iron shim 70 may be held by the winding frame 51H on the inner peripheral side of the winding frame 51H. Further, as a method of fixing the low temperature iron shim 70 to the winding frame 51H, various fixing methods such as adhesion and screwing can be employed.

(3) Further, the embodiment described above has been described in an aspect in which the nitrogen tank 14 is disposed so as to surround the helium tank 12, but an argon layer may be disposed instead of the nitrogen tank 14, and the intrusion of heat into the helium tank 12 may be suppressed by liquid argon.

A superconducting magnet device according to one aspect of the present invention includes a low temperature vessel disposed in a cylindrical shape around a central axis so as to surround a sample region including the central axis, the low temperature vessel internally having a low temperature region, a winding frame having a cylindrical shape centered on the central axis and disposed in the low temperature region, a superconducting coil including a superconducting wire wound around an outer periphery of the winding frame, the superconducting coil being excited to generate a magnetic field, a shim coil that is arranged in the sample region and generates a magnetic field by being excited, a sample region magnetic shim disposed in the sample region and cooperating with the shim coil to increase homogeneity of a magnetic field of the sample region, and a low temperature magnetic shim that is held by the winding frame in the low temperature region and enhances homogeneity of a magnetic field of the sample region.

With this configuration, the magnetic field of the sample region functioning as the measurement region can be stabilized and homogenized. In addition to the function of winding the superconducting wire, which is the original function of the winding frame, the winding frame can have a function of holding the low temperature magnetic shim. Thus, the low temperature magnetic shim stable against temperature change and electromagnetic force can be held in a low temperature region by the winding frame which is a structural basic portion of the superconducting magnet device. As a result, a dedicated holding member for holding the low temperature magnetic shim becomes unnecessary, and the superconducting magnet device can be configured with a simple structure and the space of the superconducting magnet device can be saved.

In the above configuration, the low temperature magnetic shim is desirably held by the winding frame so as to be sandwiched between the winding frame and the superconducting wire.

With this configuration, the low temperature magnetic shim is firmly sandwiched between the winding frame and the superconducting wire of the superconducting coil. Therefore, even during cooling or coil excitation, the position of the low temperature magnetic shim is stably maintained in both the radial direction and the axial direction of the winding frame. In addition, since the low temperature magnetic shim is held by the winding frame having high rigidity, vibration-proof performance against vibration transmission from the outside is high, and sufficient seismic resistance against an earthquake is expected.

In the above configuration, it is desirable that the winding frame has an engagement portion that engages with at least a part of the low temperature magnetic shim.

With this configuration, when the low temperature magnetic shim is held by the winding frame, the engagement portion can have a function of positioning the low temperature magnetic shim and the winding frame. In addition, since the centers of the superconducting coil and the low temperature magnetic shim can be accurately matched, the low temperature magnetic shim is less likely to generate a magnetic error.

In the above configuration, it is desirable that the engagement portion is a recess formed in an outer peripheral portion of the winding frame and capable of accommodating at least a part of the low temperature magnetic shim.

With this configuration, a part or the whole of the low temperature magnetic shim is accommodated in the groove-shaped recess, whereby the position of the low temperature magnetic shim with respect to the superconducting coil can be stably maintained. In addition, since the low temperature magnetic shim is fitted into the recess, it is possible to suppress movement of the low temperature magnetic shim due to an electromagnetic force between the low temperature magnetic shim and the superconducting coil.

In the above configuration, at least a part of the superconducting wire is desirably constituted by an oxide superconducting wire material.

With this configuration, even when the temperature of the sample region changes, a stable magnetic field can be generated and maintained.

In the above configuration, the low temperature magnetic shim desirably includes a first low temperature magnetic shim that homogenizes a magnetic field component parallel to the central axis in a coil magnetic field formed in the sample region by at least the superconducting coil, and a second low temperature magnetic shim that homogenizes a magnetic field component along a circumferential direction in a cross section orthogonal to the central axis in the coil magnetic field.

With this configuration, since a stable and homogeneous magnetic field can be formed in both the axial direction and the radial direction in the sample region, the function of the device in which the superconducting magnet device is mounted can be exhibited stably and accurately.

According to the present invention, there is provided a superconducting magnet device which is hardly affected by a temperature change in an installation environment of the device and can stably maintain homogeneity of a generated magnetic field.

This application is based on Japanese Patent application No. 2023-143188 filed in Japan Patent Office on September 4, 2023, the contents of which are hereby incorporated by reference.

Although the present invention has been fully described by way of example with reference to the accompanying drawings, it is to be understood that various changes and modifications will be apparent to those skilled in the art. Therefore, unless otherwise such changes and modifications depart from the scope of the present invention hereinafter defined, they should be construed as being included therein.

## Claims

1. A superconducting magnet device comprising:

   a low temperature vessel disposed in a cylindrical shape around a central axis so as to surround a sample region including the central axis, the low temperature vessel internally having a low temperature region;
   a winding frame having a cylindrical shape centered on the central axis and disposed in the low temperature region;
   a superconducting coil including a superconducting wire wound around an outer periphery of the winding frame, the superconducting coil being excited to generate a magnetic field;
   a shim coil that is arranged in the sample region and generates a magnetic field by being excited;
   a sample region magnetic shim disposed in the sample region and cooperating with the shim coil to increase homogeneity of a magnetic field of the sample region; and
   a low temperature magnetic shim that is held by the winding frame in the low temperature region and enhances homogeneity of a magnetic field of the sample region.

2. The superconducting magnet device according to claim 1, wherein the low temperature magnetic shim is held by the winding frame so as to be sandwiched between the winding frame and the superconducting wire.

3. The superconducting magnet device according to claim 1 or 2, wherein the winding frame has an engagement portion that engages with at least a part of the low temperature magnetic shim.

4. The superconducting magnet device according to claim 3, wherein the engagement portion is a recess formed in an outer peripheral portion of the winding frame and capable of receiving at least a part of the low temperature magnetic shim.

5. The superconducting magnet device according to any one of claims 1 to 4, wherein at least a part of the superconducting wire is constituted by an oxide superconductor.

6. The superconducting magnet device according to any one of claims 1 to 5, wherein
the low temperature magnetic shim includes:

a first low temperature magnetic shim that homogenizes a magnetic field component parallel to the central axis in a coil magnetic field formed in the sample region by at least the superconducting coil; and
a second low temperature magnetic shim that homogenizes a magnetic field component along a circumferential direction in a cross section orthogonal to the central axis in the coil magnetic field.

# FIG.1

FIG.2

EP 4 517 358 A1

# FIG.3

51H

73(70)    51

82

81

81    72(70)    71(70)

CL

# FIG.4

73(70)    72(70)    51

82

81    81

51H    81

81    71(70)    81

CL

# FIG.5

EXAMPLE

EP 4 517 358 A1

# FIG.6

COMPARATIVE EXAMPLE

FIG.7

EP 4 517 358 A1

# EUROPEAN SEARCH REPORT

Europäisches Patentamt
European Patent Office
Office européen des brevets

**Application Number**

EP 24 19 7486

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 736 859 A (GORE RUSSELL PETER [GB]) 7 April 1998 (1998-04-07) | 1-5 | INV.<br>G01R33/3815 |
| A | * column 3, line 53 - column 5, line 37 *<br>* figure 1 * | 6 | G01R33/3873 |
| A | US 5 900 792 A (HAVENS TIMOTHY J [US] ET AL) 4 May 1999 (1999-05-04)<br>* figures 1-3 * | 1-6 | |
| A | IGUCHI S ET AL: "Advanced field shimming technology to reduce the influence of a screening current in a REBCO coil for a high-resolution NMR magnet",<br>SUPERCONDUCTOR SCIENCE AND TECHNOLOGY, IOP PUBLISHING, TECHNO HOUSE, BRISTOL, GB,<br>vol. 29, no. 4, 11 March 2016 (2016-03-11), page 45013, XP020300257,<br>ISSN: 0953-2048, DOI:<br>10.1088/0953-2048/29/4/045013<br>[retrieved on 2016-03-11]<br>* Section 2 *<br>* figure 2 * | 1-6 | |
| A | PIAO R ET AL: "High resolution NMR measurements using a 400MHz NMR with an (RE)Ba2Cu3O7-x high-temperature superconducting inner coil: Towards a compact super-high-field NMR",<br>JOURNAL OF MAGNETIC RESONANCE, ACADEMIC PRESS, ORLANDO, FL, US,<br>vol. 263, 6 January 2016 (2016-01-06),<br>pages 164-171, XP029409179,<br>ISSN: 1090-7807, DOI:<br>10.1016/J.JMR.2015.11.015<br>* figure 1 * | 1-6 | |

**TECHNICAL FIELDS SEARCHED (IPC)**

G01R

-/--

The present search report has been drawn up for all claims

| Place of search | Date of completion of the search | Examiner |
|---|---|---|
| Munich | 17 December 2024 | Streif, Jörg Ulrich |

EPO FORM 1503 03.82 (P04C01)

Europäisches
Patentamt

European
Patent Office

Office européen
des brevets

# EUROPEAN SEARCH REPORT

**Application Number**

EP 24 19 7486

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 2019 0078757 A (KOREA BASIC SCIENCE INST [KR]; NAT UNIV KUNSAN IACF [KR]) 5 July 2019 (2019-07-05) * figures 1, 2 * | 1-6 | |
| A | YANAGISAWA Y ET AL: "Operation of a 400MHz NMR magnet using a (RE:Rare Earth)Ba2Cu3O7-xhigh-temperature superconducting coil: Towards an ultra-compact super-high field NMR spectrometer operated beyond", JOURNAL OF MAGNETIC RESONANCE, ACADEMIC PRESS, ORLANDO, FL, US, vol. 249, 18 October 2014 (2014-10-18), pages 38-48, XP029096271, ISSN: 1090-7807, DOI: 10.1016/J.JMR.2014.10.006 * figure 10 * | 1-6 | |

**TECHNICAL FIELDS SEARCHED (IPC)**

The present search report has been drawn up for all claims

| Place of search | Date of completion of the search | Examiner |
|---|---|---|
| Munich | 17 December 2024 | Streif, Jörg Ulrich |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..............................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 7486

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2024

| Patent document cited in search report | | Publication date | Patent family member(s) | | Publication date |
|---|---|---|---|---|---|
| US 5736859 | A | 07-04-1998 | DE | 69517394 T2 | 12-10-2000 |
| | | | EP | 0715180 A1 | 05-06-1996 |
| | | | GB | 2295673 A | 05-06-1996 |
| | | | JP | 3583528 B2 | 04-11-2004 |
| | | | JP | H08215171 A | 27-08-1996 |
| | | | US | 5736859 A | 07-04-1998 |
| US 5900792 | A | 04-05-1999 | EP | 0908740 A1 | 14-04-1999 |
| | | | JP | H11195527 A | 21-07-1999 |
| | | | US | 5900792 A | 04-05-1999 |
| KR 20190078757 | A | 05-07-2019 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 63272335 A

- JP 2023143188 A